(19) Europäisches Patentamt
European Patent Office
Office européen des brevets

(11) **EP 1 347 304 A2**

(12) **EUROPÄISCHE PATENTANMELDUNG**

(43) Veröffentlichungstag:
**24.09.2003 Patentblatt 2003/39**

(51) Int Cl.7: **G01R 31/36**

(21) Anmeldenummer: **03090068.2**

(22) Anmeldetag: **17.03.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **22.03.2002 DE 10214218**

(71) Anmelder: **Slamecka, Ernst**
**13595 Berlin (DE)**

(72) Erfinder: **Slamecka, Ernst**
**13595 Berlin (DE)**

(54) **Verfahren zum Prüfen von Hochspannungs-Leistungsschaltern**

(57) A: Seitherige Bedingung für Äquivalenz dieser synthetischen Prüfschaltung mit direkter Prüfschaltung:

Schwingstrom bzw. homogener Hochstrom haben im Strom-Null gleiche Stromsteilheit

erweist sich als nicht hinreichend.

B: Hohe Lichtbogenspannungen bei Prüfschalter und Hilfsschalter können den Hochstrom unzulässig verzerren. Abhilfe:

Erhöhnug der Spannung des Hochstromkreises über Transformator involviert technische und wirtschaftliche Nachteile.

Problemlösungen

Zu A: Einführung einer zweiten Äquivalenzbedingung:

gleich große Emission von Lichtbogenenergie im Prüfschalter in der synthetischen wie in der direkten Prüfschaltung zumindest in einem charakteristischen jeweils gleich großen Zeitintervall der Ströme vor Strom-Null.

Daraus ergibt sich als praktische Einstellgröße der synthetischen Prüfschaltung die "Folgestrom-Flußdauer der Äquivalenz". Berechnungsverfahren werden mitgeteilt. Ergebnisse von Rechnung und Vergleichsversuchen stimmen gut überein.

zu B: Den Hochstrom im Hilfsschalter reduziert ein Gegenstrom in autonomem , diesem Schalter parallelzuschaltendem Gegenstromkreis. Kombiniert mit relativ verzögerter Kontakttrennung wird Hilfsschalter erheblich entlastet und durch reduzierte Unterbrecherwirkung seine Lichtbogenspannung entsprechend verkleinert. Rationalisierungspotential:

Einsparen des Transformators und - besonders für Prüfung von Vakuumschaltern interessant - als Hochstromquelle: Generator mit Nennspannung gleich oder kleiner 1 kV.

EP 1 347 304 A2

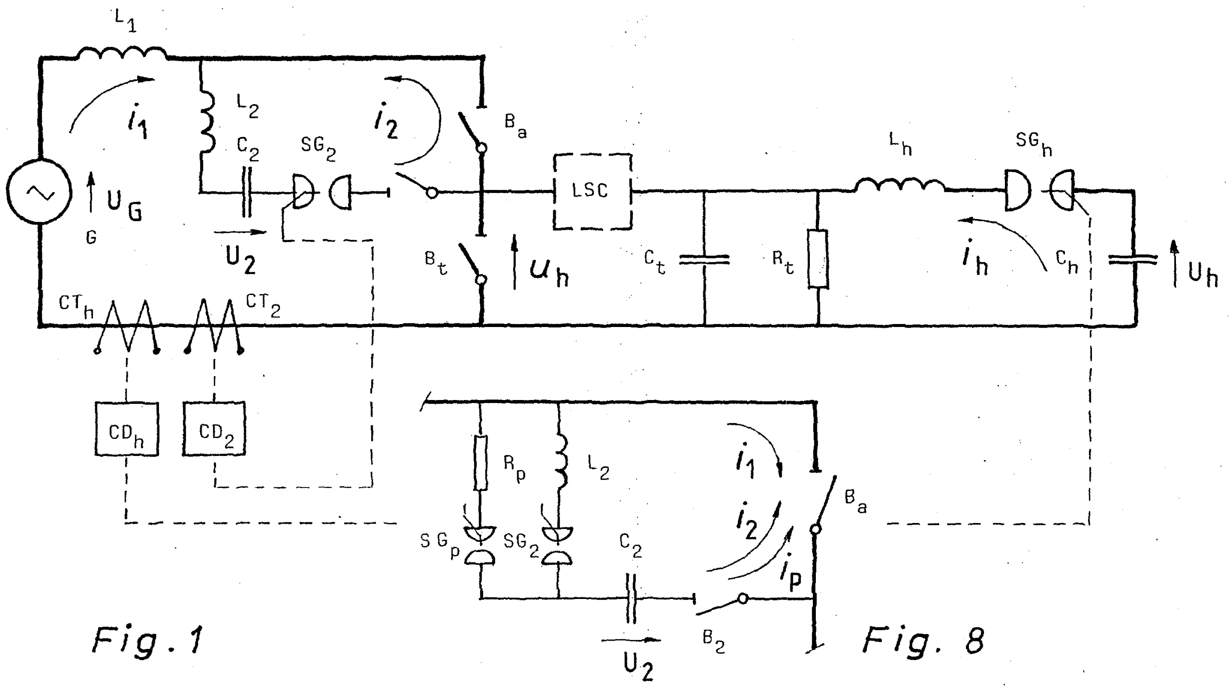
L1
L2
C2
SG2
i1
i2
Ba
Bt
UG
G
U2
uh
LSC
Ct
Rt
Lh
SGh
ih
Ch
Uh
CTh
CT2
CDh
CD2
Rp
SGp
ip
B2

Fig.1

Fig. 8

## Beschreibung

Die Erfindung betrifft synthetische Schaltleistungsprüfschaltungen mit den im Oberbegriff des Patentanspruchs 1 genannten Grundmerkmalen. Eine synthetische Prüfschaltung dieser Art ist bekannt durch IEC-Publication 60427, Third edition 2000-04, S. 95, Fig. BB1.

Der "Typical current injection circuit with voltage circuit in parallel with the test circuit-breaker" ist Anfang der Fünfzigerjahre des vergangenen Jahrhunderts auf Initiative von Professor J. Biermanns, damaliger Direktor des neuen Hochspannungsinstituts der AEG in Kassel-Bettenhausen und früher Direktor der nicht mehr existierenden "AEG-Transformatorenfabrik Oberschöneweide", Berlin, entwickelt worden, um die direkte Prüfleistung des einen Teil des Instituts bildenden Hochleistungsprüffeldes zu verstärken.

Während der Entwicklungsarbeiten war diese synthetische Prüfschaltung im Institut als "Kunstschaltung" bekannt und auch Biermanns hat nur von der "Kunstschaltung" gesprochen.

Nach der Inbetriebnahme der "Kunstschaltung" 1953 wurden ihr von der damaligen Entwicklungsleitung der AEG in Frankfurt a. M. die Bezeichnungen "Weilschaltung" und später "Weil-Dobkeschaltung" zugeordnet:

> "Die Weilschaltung, eine Schaltung zur Prüfung von Hochleistungsschaltern", von E. Slamecka, in: Festschrift zur Eröffnung des AEG-Hochspannungsinstituts in Kassel, 1953, S. 52 bis 57, bzw.
> "Untersuchungen über die AEG-Prüfschaltung für Hochleistungsschalter nach "Weil-Dobke", von E. Slamecka, Dissertationsschrift, Technische Hochschule Graz, 1955.

Eine genauere Analyse des Patents von F. Weil auf die von ihm erfundene synthetische Prüfschaltung, DE 962 731, und des Patents DE 975 303 von G. Dobke, weist jedoch beide Namenszuordnungen als offensichtlich auf Versehen beruhend und daher objektiv nicht berechtigt aus.

Der von Weil in seiner Patentschrift beschriebene Stand der Technik - die "Kunstschaltung" der AEG - wurde versehentlich als sein Erfindungsgegenstand angesehen und so fälschlich mit dem Namen "Weil" verbunden.

Der "Zusatz zum Patent 962 731" - Patent auf die tatsächliche Weilschaltung - das Zusatzpatent 975 303 von G. Dobke, stellt nach offenbartem Prinzip und dargestellten Stromverlauf den von F. Weil in seiner Patentschrift beschriebenen und zu verbessernden Stand der Technik dar - eben die "Kunstschaltung" der AEG - und bildet faktisch den patentierten Erfindungsgegenstand von F. Weil zurück auf diesen Stand der Technik von 1942, erfunden von unbekannten Erfindern in der einstigen "TR0". Auch dieses Faktum wurde seinerzeit übersehen und so erhielt die "Kunstschaltung" der AEG - auch fälschlich - noch den Zunamen "Dobke".

Den Ausführungen von F. Weil in seiner Patentschrift zum Stand der Technik: "Eine derartige bekannte Prüfanordnung (die "Kunstschaltung") hat den Nachteil, daß der Verlauf des Hauptstromes kurz vor seinem Nulldurchgang bzw. der Einsatz der Hochspannung als Wiederkehrspannung nicht den Verhältnissen der natürlichen Prüfung entspricht. Dies ergibt sich daraus, daß die Hochspannungsquelle bereits vor dem Nulldurchgang des Hauptstromes auf die Prüfschaltstelle geschaltet ist, so daß sich beide Ströme in der Schaltstrecke überlagern und einen zu hohen Wert ergeben." ist noch hinzuzufügen:

Die Stromüberlagerung kann auch eine Unterbeanspruchung des Prüfschalters ergeben, falls das Nullwerden des Stroms der Hochspannungsquelle zu weit entfernt vom Nullwerden des Hauptstroms stattfindet.

In der bereits zitierten IEC-Publication 60427 sind auf Seite 23 beziehungslos Grenzwerte für die Dauer des alleinigen Flusses des Schwingstroms im Prüfschalter angegeben - minimal 200 μs, maximal 500 μs - die nicht unter bzw. überschritten werden sollen. Eine Information, ob eine Äquivalenz der Beanspruchung des Prüfschalters in dieser synthetischen Prüfschaltung mit seiner Beanspruchung in einer direkten Prüfschaltung existiert und - gegebenenfalls - wann innerhalb dieses Zeitintervalls ein Strom-Null des Schwingstroms erfolgen soll, wird offengelassen.

Den Hilfsschalter entlastet im Ablauf der synthetischen Prüfung keine Überlagerung des Hochstroms mit einem Schwingstrom entgegengesetzter Polarität, wie dies bei einer anderen bekannten synthetischen Prüfschaltung systemimmanent ist: IEC-Publication 60427, Third edition 2000-04, S. 97, Fig. BB3 und Fig. BB4. Daher sind bei in etwa gleich großem Stromunterbrechungsvermögen von Hilfsschalter und Prüfschalter auch die Lichtbogenspannungen beider Schalter etwa gleich groß. Diese im Hochstromkreis in Reihe liegenden Spannungen können den Hochstrom erheblich verzerren.

Die bekannte Abhilfe, ein Hochstromtransformator, um die treibende Spannung im Hochstromkreis zu erhöhen, ist aufwendig und reduziert seine Stromergiebigkeit.

Bei dem vorstehend dargelegten Stand der Technik stellen sich folgende Erfindungsaufgaben.

- die Entscheidbarkeit des Problems klären, d.h. kann grundsätzlich eine Äquivalenz der Beanspruchung des Prüfschalters in dieser synthetischen Prüfschaltung im Vergleich mit einer direkten Prüfschaltung existieren?

- Entwickeln von Verfahren, zur Ermittlung einer Einstellgröße für die synthetische Prüfschaltung, bei der die Beanspruchung darin derjenigen in einer direkten Prüfschaltung äquivalent ist.

- die Beanspruchung des Hilfsschalters durch die in die Schaltkammer emittierte Lichtbogenenergie erheblich verkleinern, um bei dadurch erheblich reduzierter Unterbrecherwirkung und dementsprechend kleinerer Lichtbogenspannung sowie Stromverzerrung den Hochstromtransformator einzusparen.

Die vorstehend genannten erfinderischen Aufgaben werden durch die Merkmale des Hauptanspruchs und der Nebenansprüche gelöst; vorteilhafte Weiterbildungen sind in den Unteransprüchen beschrieben.
Das Wesentliche und Vorteilhafte der Erfindungen besteht in folgendem:

- eine bekannte, notwendige aber nicht hinreichende Äqivalenzbedingung wird durch eine zweite Äquivalenzbedingung ergänzt: gleichgroße Lichtbogenenergie-Emission in der Schaltkammer des Prüfschalters in einem charakteristischen, für die synthetische und die direkte Prüfschaltung jeweils gleichen Zeitintervall.

- für die aus der zweiten Äquivälenzbedingung sich ergebende Einstellgröße dieser synthetischen Prüfschaltung auf äquvalente Beanspruchung des Prüfschalters, die "Folgestrom -Flußdauer der Äquivalenz", werden Verfahren zu deren betriebsnotwendigen zahlenmäßigen Ermittlung hergeleitet; Ergebnisse von Rechnung und Versuch stimmen relativ gut überein.

- den Hochstrom im Hilf sschaltery reduziert ein Gegenstrom in einem autonomen, dem Hilfsschalter parallelzuschaltenden LC- oder RC-Stromkreis; dadurch wird ein Hilfsschalter mit erheblich verkleinerter Lichtbogenspannung ermöglicht, z.B. durch Vakuumschalter dargestellt, und die Stromverzerrung bleibt ohne Hochstromtransformator in zulässigen Grenzen; auch eine Verkürzung der Lichtbogenzeit durch relativ verzögerte Kontakttrennung kann den Hilfsschalter entlasten und besonders wirksam: beide Maßnahmen kombinieren.

Die Erfindungen werden anhand von Ausführungsbeispielen näher erläutert; es zeigen.

Fig. 1: Schaltplan der synthetischen Prüfschaltung einschließlich Gegenstromkreis zur Stromreduzierung im Hilfsschalter

Fig. 2: Hochstromverlauf im Hilfsschalter, Reduktion der Momentanwerte durch Gegenstrom

Fig. 3: Gegenstromverlauf, dargestellt durch Schwingstrom

Fig. 4: Hochstromverlauf im Prüfschalter mit Hochspannungsschwingstrom als Überlagerungsstrom und Folgestrom

Fig. 5 Einschwingspannungsverlauf

Fig. 6: graphische Darstellung der Funktionsgleichung (1)

Fig. 7: Graph der "Folgestromdauer der Äquivalenz", bezogen auf die Schwingstrom-Halbschwingungsdauer in Abhängigkeit von dieser Halbschwingungsdauer, ermittelt aus Graph, Fig. 6, $\hat{=}$ AER=1

Fig. 8: Schaltplan des LC-Gegenstromkreises mit Vorstromkreis

Fig. 9: Schaltplan eines RC-Gegenstromkreises mit Vorstromerzeugung

Fig.10: Hochstromverlauf im Hilfsschalter mit RC-Gegenstrom

Fig.11: Gegenstrom, dargestellt durch aperiodischen Strom

Fig. 12: Funktionswerte-Fabelle 1

Fig. 13: Funktionswerte-Tabelle 2

Den Hochstromkreis, Fig. 1, bilden im wesentlichen ein Generator (G) als Hochstrom-Quelle mit oder ohne nachgeschaltetem Transformator - resultierende Induktivität ($L_1$) gegebenenfalls eine zusätzliche Strombegrenzungs-

induktivität mitrepräsentierend - ein nicht dargestellter Sicherheitsschalter und ebenso ein Draufschalter, ein Hilfsschalter ($B_a$) und ein Prüfschalter ($B_t$).

Den Hochspannungsschwingkreis bilden im wesentlichen eine auf hohe Spannung aufladbare Kapazität ($C_h$), eine Induktivität ($L_h$), eine steuerbare Schaltfunkenstrecke (triggerable sparc gap) ($SG_h$), eine Kapazität ($C_t$) parallel zum Prüfschalter, evtl. ein damit in Reihe geschalteter ohmscher Widerstand, ein ohmscher Widerstand ($R_t$) parallel zum Prüfschalter und evtl. eine Simulation eines Freileitungsabschnitts (line impedance simulating circuit) (LSC) zwischen Prüfschalter und Kapazität ($C_t$).

Die Steuerung besteht aus einem Hochstromwandler ($CT_h$) und aus einem Gerät zum Erzeugen eines zeitlich einstellbaren Zündimpulses für die Schaltfunkenstrecke ($CD_h$).

Bei geschlossenen Sicherheits- und Draufschalter und öffnenden Hilfs- und Prüfschalter zündet kurz vor dem Nulldurchgang des Lichtbogenstroms ($i_1/B_a$) und ($i_1/B_t$) in den beiden letztgenannten Schaltern, Fig. 2, 4 - wobei schon eine Möglichkeit der Stromunterbrechung besteht - die Schaltfunkenstrecke ($SG_h$) im Zeitpunkt $t_0$. Daraufhin überlagert sich ein Hochspannungssehwingstrom ($i_h$) dem Hochstrom $i_1/B_t$ im Prüfschalter, Summenstrom: $i_1$ + $i_h$.

Im Strom-Null, -- Zeitpunkt $t_1$, wird der Hochstrom ----- durch den Hilfsschalter unterbrochen. Im Prüfschalter fließt der Hochspannungsschwingstrom als Folgestrom $i_h/B_t$ weiter und erreicht im Zeitpunkt $t_2$ den Nullwert mit derselben Steilheit (bei vernachlässigter Dämpfung) wie vorher der Hochstrom. Angenommen, die Kontakte des Prüfschalters befinden sich in ausreichender Unterbrecherdistanz, kehrt die Spannung $U_h$ des Hochspannungsschwingkreises zunächst als transiente Spannung $u_h$ wieder, Fig. 5. Behufs Gleichung und Verlauf dieser Einschwingspannung auch für Varianten des Hochspannungsschwingkreises, Fig. 1, siehe: "Schaltvorgänge in Hoch- und Niederspannungsnetzen", von E. Slamecka und W. Waterschek, Verlag: Siemens AG Berlin und München 1972.

Wenn die Dauer eines Schwingstroms bestimmter, gleichbleibender Frequenz als Folgestrom des Hochstroms sich stetig und monoton verändert von einem sehr kleinen Wert - Strom-Null (current zero) des Folgestroms liegt sehr nahe beim früheren Strom-Nullwert des Hochstroms und läßt eine Überbeanspruchung des Prüfschalters vermuten - hin zu einem ----- erheblich größeren Wert - Strom-Null ---- des Folgestroms liegt zeitlich schon erheblich weiter entfernt vom früheren Strom-Null ----- des Hochstroms und läßt eine Unterbeanspruchung des Prüfschalters vermuten - kann aufgrund des dabei sich ändernden Quantums an emittierter Lichtbogenenergie davon ausgegangen werden, daß es zwischen den Grenzwerten der Folgestromdauer eine solche Folgestromdauer gibt, bei der die Beanspruchung des Prüfschalters in der Prüfschaltung mit synthetischem Strom der Beanspruchung des Prüfschalters in einer Prüfschaltung mit homogenem Hochstrom äquivalent ist.

Ab dem Parallelschalten des Hochspannungsschwingkreises zum Prüfschalter, $t_o$, beansprucht seine Schaltkammer die aus dem Ausschaltlichtbogen austretende thermische Energie mit einem Anteil des Hochstroms und des Schwingstroms bis $t_1$ und mit einem Anteil des Schwingstroms allein bis $t_2$, Fig. 4.

Im Zeitintervall von der Dauer einer Halbschwingung des Schwingstroms beansprucht bei der direkten Prüfschaltung die Schaltkammer des Prüfschalters die aus dem Ausschaltlichtbogen eines denn homogenen Ausschaltstroms austretende thermische Energie.

$$AER = \frac{W_2 + W_3}{W_1} \qquad (1)$$

$$W_1 = \int_0^{\pi/n} \sin x \, dx$$

$$W_2 = \int_0^{[\pi - \arcsin(i_h/I_h)]/n} \sin x \, dx$$

$$W_3 = e^{k\pi/n} \int_0^{\pi/n} e^{-knx} \sin nx \, dx$$

$$\pi \frac{\Delta t_s}{T_{h/2}} = arc\ sin(i_h/I_h) = \pi\vartheta_s$$

$$n = I_1/I_h = \nu_0/\omega = T_1/T_h$$

$$k = \delta/\nu_0 = [1 - (\nu/\nu_0)^2]^{0,5}$$

$$\delta = R/2L$$

Das Verhältnis dieser zugeordneten Energien beschreibt Gleichung (1) als Funktion der Dauer $\Delta t_s$ des alleinigen Schwingstromflusses im Prüfschalter mit den Gleichungsparametern n und k laut angegebener Definition.

In dieser Gleichung sind Dämpfung des Schwingstroms berücksichtigt und --- Defizit an Stromsteilheit des Schwingstroms im Strom-Nullwert kompensiert. Graphen von Schwingstromverläufen mit verschiedener Dämpfung und zugehörige Gleichungen enthalten Bild 121 bzw. Tabelle 33 des bereits zitierten Lehrbuchs.

Graphen zur Gleichung (1) für verschiedene n-Werte bei ungedämpftem Schwingstrom, k = 0 , zeigt Fig. 6; damit ergeben sich z.B. für n=10 und $i_h/I_h$ = 1: $\Delta t_s$ = 500 µs --- und AER=0,66 - eine Unterbeanspruchung des Prüfschalters um 34% liegt vor.

Äquivalenz der thermischen Beanspruchung des Prüfschalters besteht im Schnittpunkt der Funktionsgraphen mit der Äquivalenz-Horizontalen

$$AER = 1; \qquad (2)$$

aus dem Graph für n=10, Fig. 6, erhält man für das gewählte Beispiel die Äquivalenz-Folgestrom-Flußdauer zu $\Delta t_{se}$= 230 µs.

Bei $\Delta t_s$ = 200 µs --- wird der AER-Graph für n= 10 durch das Ergebnis von Vergleichsversuchen mit etwa dieser Folgestromdauer bestätigt, siehe Markierung durch Kreis, Fig. 6, und: "Prüfung von Hochspannungsschaltern in der AEG-("Kunstschaltung")", von F. Petermichl, VDE-Fachberichte, 18. Band, 1954.

Bezieht man die aus dem Graph, Fig. 6, ermittelten Folgestromdauern der Äquivalenz auf die einer jeden von ihnen zugrunde liegende Halbschwingungsdauer und trägt man die Zahlenwerte in einem kartesischen Koordinatensystem über der Bezugs-Halbschwingungsdauer ein, ergibt sich der Funktionsgraph

$$\Delta t_{se}/(T_h/2) = \vartheta_{se} = f(T_h/2), \text{ Fig. 7;}$$

von $f_h$ = 1000 Hz kommend bis etwa 500 Hz verläuft die bezogene Äquivalenz-Folgestromdauer praktisch konstant, um dann - mit sehr geringer Steigung - praktisch linear anzusteigen.

Hinsichtlich Abweichungen von der Äquivalenz-Folgestromdauer $\Delta t_{se}$ ist eine Toleranz von plus/minus 30% angegeben, wobei eine Veränderung von $\Delta t_{se}$ sich auf das Äquivalenz-AER stark abgeschwächt auswirkt wie später folgende Funktionswerte-Tabellen zeigen werden.

Die bezogene Äquivalenz-Folgestrom-Flußdauer läßt sich auch durch eine algebraische Gleichung (3) beschreiben bzw. ermitteln, deren Herleitung u.a. auch Gleichung (2) zugrunde liegt:

$$\frac{\Delta t_{se}}{T_h/2} = \vartheta_{se} = 1 - [(\frac{\varkappa_2}{\varkappa_1})(1 - \frac{W_3}{W_1})]^{0,5} \quad (3)$$

$$\varkappa_1 = \frac{\int_0^{\pi/n} x\,dx}{W_1} = 1 + \varepsilon_1$$

$$\varkappa_2 = \frac{\int_0^{\pi(1-\vartheta_{se})/n} x\,dx}{W_2} = 1 + \varepsilon_2$$

$$\varkappa_2 < \varkappa_1$$

$$(\varkappa_2/\varkappa_1)^{0,5} = 1 + (\varepsilon_2 - \varepsilon_1)/2$$

Das Problem, daß die zu ermittelnde Größe $\vartheta_{se}$ auch im Term der rechten Seite der Gleichung (3) vorkommt, löst sich praktisch durch eine Besonderheit dieses Terms wie unter Gleichung (3) erläutert - Reihenentwicklung und Vernachlässigung des Produkts kleiner Größen; falls erwünscht, läßt sich mit dem ersten $\vartheta_{se}$-Wert - Kappa-Verhältnis ungefähr gleich Eins - dafür ein noch genauerer Wert ermitteln und damit in einem zweiten Rechnungsgang die Genauigkeit der Rechnung --- weiter erhöhen.

Der von Gleichung (3) beschriebene Graph für $\vartheta_{se}$ mit k=0 verläuft praktisch deckungsgleich mit dem teils numerisch, teils graphisch ermittelten Verlauf von $\Delta t_{se}$ in Fig. 7; dies bestätigend leitet sich aus Gleichung (3) für $f_h$ gleich/größer 500 Hz und k=0,00 her: $\vartheta_{se}$ = const = 0,23.

Und auch die unter Dämpfungseinfluß aus Gleichung (3) ermittelten $\vartheta_{se}$-Werte sind praktisch identisch mit den dafür numerisch und graphisch ermittelten $\vartheta_{se}$-Werten - nicht mehr niedergeschrieben.

Abweichungen von der Äquivalenz-Folgestrom-Flußdauer zumindest bis plus oder minus 30% wirken sich auch hier auf das AER der Äquivalenz nur gering aus. ------------------- Dies zeigen die einander zugeordneten Zahlenwerte der Funktionswerte-Tabelle 1 für Schwingstromfrequenzen 500 Hz und 250 Hz bei Dämpfungen von k=0 bzw. k=0,03.

Im Vergleich kann sich bei beziehungslos festgesetzten Grenzwerten für die Folgestromflußdauer - Zahlen schon an früherer Stelle genannt - eine die Toleranz-AER-Werte - AER(p) - laut Tabelle erheblich über- bzw. unterschreitende Beanspruchung des Prüfschalters ergeben:

- festgelegte Folgestromdauer 200 µs, potentiell zugeordneter Schwingstrom mit $f_h$ = 250 Hz: AER = 1,25, d.h. um 25% zu große thermische Beanspruchung des Prüfschalters

- festgelegte Folgestromdauer 500 µs, potentiell zugeordneter Schwingstrom mit $f_h$= 500 Hz: AER = 0,66, d.h. um 34 % zu kleine thermische Beanspruchung des Prüfschalters

Ein von der Gleichung (3) beschriebener Graph oder auch ein numerisch/graphisch ermittelter, Fig. 7, läßt sich in seinem mit geringer Steigung linear ansteigendem Verlauf zumindest abschnittsweise durch eine horizontale Gerade annähern:

$$\vartheta_s = const = \vartheta_{sc} \qquad (4)$$

Im Frequenzbereich oberhalb von $f_h$ = 500 Hz ist eine Horizontale bereits funktionsbedingt gegeben, Fig. 7; Im Frequenzbereich unterhalb von $f_h$= 500 Hz liegt eine praktisch geeignete, den Funktionsgraph schneidende Horizontale z.B. mit

$$\vartheta_{sc} = 0,24$$

vor; die Horizontale kann sich dem Funktionsgraph auch nur einseitig nähern oder ihn berühren.

Für Abweichungen von der gewählten Basis gilt:

$$\vartheta_{sp} = \vartheta_{sc} ( 1 \pm p/100 ) \qquad (5)$$

mit p = 30% als Maximalwert. Zahlenwerte der zugehörenden Funktion AER(p) mit k = 0,00 und 0,03 für Schwingstromfrequenzen von 500 Hz bis 200 Hz sind angegeben in der Funktionswerte-Tabelle 2, Fig. 13. Diese Tabelle zeigt auch, Spalte 2, daß bei dem gewählten $\vartheta_{sc}$ = 0,24 die für die Abschnittsgrenzen errechneten AER-Werte vom Äquivalenz-AER-Wert Eins nur wenig abweichen, bei $f_h$= 250 Hz um maximal 2%.

Der graphischen Darstellung von Stromüberlagerung und Stromfolge im Prüfschalter, Fig.4 , liegen folgende Daten zugrunde:

$$n = 5, k = 0,00, i_h/I_h = 0,707,$$

$$\Delta t_s = 500 \text{ Mikros}, \vartheta_s = 0,25, AER = 0,99 ;$$

die Abweichungen von $\vartheta_{se}$ = 0,243 und AER = 1 betragen + 2,9% bzw. - 1%.

Eine Möglichkeit, den Hilfsschalter zu entlasten, um letztlich den Hochstrom-Transformator zu ersparem, ergibt sich wie folgt: Beim Öffnen der Kontakte des Hilfsschalters statt zu Beginn erst im Scheitel der letzten Schwingung des Hochstroms halbiert sich die den Schalter beanspruchende Lichtbogenenergie, wie es die Integrale über die Produkte aus Lichtbogenstrom und konstant angenommener Lichtbogenspannung über die verschiedenen Integrations-Zeitintervalle zeigen - nicht dargestellt.

Bei dieser erheblich verkleinerten thermischen. Vorbeanspruchung kann die Löschmitteleinwirkung auf den Schaltlichtbogen auch erheblich verkleinert werden und damit verkleinert sich die Lichtbogenspannung des Hilfsschalters. Es ist daher nützlich - allgemein ausgedrückt - den Hilfsschalter zeitlich so auszulösen, daß die Dauer des Schaltlichtbogens in der Schaltstrecke kürzer ist als die Dauer der letzten Schwingung des Hochstroms.

Außerdem ist es günstig, wenn in der verbleibenden Zeit bis zum Nullwert des Hochstroms die Kontakte des Hilfsschalters mittels eines wirtschaftlichen Kontaktantriebs die Isolierdistanz für die wiederkehrende Spannung erreichen.

Die Gegenläufigkeit in diesen Maßnahmen am Hilfsschalter - einerseits: Verkleinern der Lichtbogenenergie durch relatives Verzögern der Kontakttrennung und andererseits: Erhöhen der Kontaktgeschwindigkeit verbunden mit erhöhtem Aufwand für den Kontaktantrieb - läßt ein technisch-wirtschaftliches Optimum erwarten bei einer Kontakttrennung im Bereich des Scheitelwerts des Hochstroms.

Dann verbleiben - bei nur noch halber von der Schaltkammer zu bewältigender Lichtbogenenergie - für die Kontakte noch etwa 5 ms bis zum der vollen Isolierdistanz; mit einer Kontaktgeschwindigkeit von z.B. v = 2 m/s sind es 10 mm pro Unterbrechereinheit eines Vakuum.schalters, dessen Kontakte schon bei der Trennung diese Geschwindigkeit besitzen.

Der Hilfsschalter $B_a$ läßt sich auch durch eine neuartige Technik der Stromüberlagerung erheblich von der Lichtbogenbeanspruchung entlasten, Ziel bleibt: kein Hochstromtransformator.

Dem Hilfsschalter ist ein zunächst offener Schwingkreis parallelgeschaltet bestehend aus den Bauelementen: auf Potential aufladbare Kapazität ($C_2$), Induktivität ($L_2$), Schaltfunkenstrecke ($SG_2$), Hilfsschalter ($B_2$), Fig. 1. Vor dem letzten Nullwert des Hochstroms $i_1$, bei leitfähiger Schaltstrecke des Schalters $B_2$, wird der Schwingkreis durch Zünden der Funkenstrecke $SG_2$ geschlossen, Zeitpunkt $t_0$, Fig. 2, 3. Der Schwingung des Hochstroms $i_1$ überlagert sich dann eine Halbschwingung des Schwingstroms $i_2$ mit entgegengesetzter Polarität, etwa derselben Steilheit im Nullwert aber höherer Frequenz und im Frequenzverhältnis verkleinerter Amplitude. Das Strom-Null des Schwingstroms erfolgt im Zeitpunkt $t_1$ noch vor dem Strom-Null des Hochstroms im Zeitpunkt $t_1$ und spätestens auch zu diesem Zeitpunkt.

Diese Abstimmung der beiden Ströme ergibt im Deckungsbereich ihrer annähernd linearen Verläufe näherungsweise einen Strom nahezu gleichbleibender Höhe. Diese Höhe läßt sich durch Annähern des Strom-Nulls an das Strom-Null des Hochstroms praktisch beliebig verkleinern und damit auch'die Strombeanspruchung des Hilfsschalters $B_a$.

Die Anfangsspannung $U_2$ an der Kapazität $C_2$ braucht nur deutlich größer zu sein als die durch den Stromüberlagerungseffekt niedrig gehaltene Bogenspannung des Hilfsschalters $B_a$, z.B. 500V bei etwa 50V Bogenspannung eines Vakuumschalters.

Nach dem Strom-Null des Schwingstroms $i_h$ im Prüfschalter werden die Schaltstrecken der beiden Hilfsschalter $B_a$ und $B_2$ durch die Einschwingspannung $u_h$ , Fig. 5, beansprucht. Dabei hatte der Hilfsschalter $B_2$ nur den nach Amplitude und Flußdauer relativ kleinen Schwingstrom $i_2$ zu unterbrechen; im Ausführungsbeispiel sind es 8 kA bei 200 Hz, wenn der Ausschaltstrom des Prüfschalters 32 kA bei 50 Hz beträgt. Die Bemessung des Entlastungsschwingkreises ergibt sich im Zuge der Minimierung des Gesamtaufwands inklusive des Aufwands für den Hilfsschalter $B_a$.

Gemäß Schaltplan, Fig. 1, müssen die Kontakte des Schalters $B_2$ bis zum Zünden der Schaltfunkenstrecke $SG_2$ geschlossen bleiben, damit daraufhin der Entlastungs-Schwingstrom $i_2$ fließen kann: bis zum Erreichen der Isolierdistanz steht jetzt nur sehr wenig Zeit zur Verfügung. Der Mehraufwand für eine entsprechend hohe Kontaktgeschwindigkeit läßt sich vermeiden durch einen Lichtbogen-Vorstrom (arcing pre-current) $i_p$. Dazu sind der Induktivität $L_2$ und Schaltfunkenstrecke $SG_2$, Fig. 1, ein ohmscher Widerstand ($R_p$) und eine Schaltfunkenstrecke ($SG_p$) parallelgeschaltet, Fig. 8.

Trennen sich nun die Kontakte des Schalters $B_2$ - der Einfachheit halber etwa gleichzeitig mit den Kontakten des Hilfsschalters $B_a$ - und wird dabei - oder kurz vorher - die Schaltfunkenstrekke $SG_p$ gezündet, fließt über dessen Kontakte der Vorstrom $i_p$ mit z.B. 10 A; sein Lichtbogen hält die Schaltstrecke des Schalters $B_2$ leitfähig bis zum späteren Zünden der Schaltfunkenstrekke $SG_2$, Zeitpunkt $\tau_o$.

Alternativ kann dem Hochstrom im Hilfsschalter $B_a$ zur Stromentlastung auch ein aperiodischer Strom $i'_2$ mit entgegengesetzter Polarität gemäß Schaltplan in Fig. 9 überlagert werden. Spätestens bei Kontakttrennung des Hilfsschalters $B_a$ schließt die durch ein nicht dargestelltes Steuergerät gezündete Schaltfunkenstrecke $SG_p$ den durch die ohmschen Widerstände $R_2$ , $R_p$ und die Schalter $B_2$ , $B_a$ gebildeten Vorstromkreis.

Durch die Schalter $B_2$ und $B_a$ fließt der kleine Vorstrom $i_p$ praktisch wieder bestimmt durch den Vorstrom-Widerstand $R_p$. Bei Kontakttrennung im Schalter $B_2$ geht dieser Strom in einen Lichtbogenstrom über und hält seine Schaltstrecke leitfähig. Zur Zeit $\tau_0'$ wird die Schaltfunkenstrecke $SG_2$ durch das Steuergerät $CD_2$ Fig. 1, gezündet und damit der Vorstrom-Widerstand $R_p$ überbrückt.

Der einsetzende Entlastungsstrom $i_2'$, auch ein exponentiell abklingender Gleichstrom, Fig. 11, überlagert sich dem Hochstrom $i_1$ im Hilfsschalter $B_a$ mit entgegengesetzter Polarität. Der sultierende Strom

$$( i_1 + i_2' )$$

im Zeitintervall

$$( \tau_1' - \tau_0' ), \qquad \text{Fig. 10,}$$

erfordert eine erheblich geringere Unterbrecherwirkung mit entsprechend kleinerer Lichtbogenspannung des Hilfsschalters $B_a$. Der Einfluß verteilter Leitungsinduktivität auf die Stromverläufe von $i_2'$ und ($i_1$+$i_2'$) wurde vernachlässigt. Um eine gegebenenfalls nützliche besondere Form des aperiodischen Stroms $i_2'$ zu erhalten, kann der Entlastungsstromkreis durch eine konzentrierte Induktivität ergänzt werden - nicht dargestellt; wegen Stromverlaufsgraphen und Berechnungsformeln siehe Lehrbuch-wie bereits zitiert, Seiten 272/3.

Um den Entlastungsstrom $i_2'$ zu unterbrechen, wird im Unterbrechungszeitpunkt $\tau_1'$ die Schaltfunkenstrecke ($SG_c$) gezündet; dafür kann das Steuergerät $CD_2$ mitverwendet werden, wenn es einen zweiten Zündimpuls erzeugt, der um die Zeit ($\tau_1'$ - $\tau_0'$) verzögert an die Zündelektrode der Schaltfunkenstrecke $SG_c$ geschaltet wird. Diese Funkenstrecke schließt den Stromkreis mit der Kapazität ($C_c$) - auf die Gleichspannung $U_c$ aufgeladen - und dem ohmschen Widerstand ($R_c$). Der einsetzende Strom-Null Erzeuger-Strom ($i_c$) (current zero generating current) in diesem gleichfalls durch die Schalter $B_2$ und $B_a$ geschlossenen Stromkreis ist nach Größe und Polarität so bemessen, daß er im Schalter $B_2$ den Entlastungsstrom $i_2'$ zum Unterbrechen auf Null reduziert. Dieser ein Strom-Null erzeugende Strom kann auch ein oszillierender Strom sein in einem höherfrequenten Schwingkreis.

Ohmscher Vorwiderstand $R_p$ und zugehörige Schaltfunkenstrekke $SG_p$, Fig. 9, können - analog zu Fig. 8 - auch parallel zu ohmschem Widerstand $R_2$ und zugehöriger Schaltfunkenstrecke $SG_2$ angeordnet werden.

Besonders bei einem Schwingstrom als Entlastungsstrom des Hilfsschalters $B_a$ können Schalter $B_2$ und Schaltfunkenstrecke $SG_2$ gemeinsam durch eine Schnellschalteinrichtung mit feststehenden Kontakten - im Vakuum oder in $SF_6$-Atmosphäre - vorteilhaft ersetzt werden. Das Einschalten bei dieser Schalteinrichtung bewirkt ein Zündfunke über eine Hilfsfunkenstrecke an einer der beiden feststehenden Kontakte - ausgelöst durch die Steuereinrichtung $CD_2$ wie in Fig. 1 dargestellt. Der dann fließende Schwingstrom wird im ersten Strom-Null durch die feststehende Kontaktanordnung mit Schaltleistungsvermögen unterbrochen - zeichnerisch nicht dargestellt.

Das Reduzieren der Beanspruchung des Hilfsschalters durch die thermische Energie des Hochstromlichtbogens mittels der vorstehend erläuterten Gegenstromkreise läßt sich durch eine ergänzende Maßnahme erheblich verstärken. Zu diesem Zweck wird vor Beginn der Überlagerung des Gegenstroms die Dauer des Lichtbogenstromflusses dadurch verkürzt, daß man die Kontakte des Hilfsschalters $B_a$ bezüglich des vorletzten Hochstrom-Null zeitverzögert öffnen läßt.

**Patentansprüche**

1. Verfahren zum Prüfen von Hochspannungs-Wechselstrom-Leistungsschaltern in einer synthetischen Prüfschaltung

   mit einem eine Hochstromquelle (G) in Reihenschaltung mit zumindest einem Hilfsschalter ($B_a$) und einem Prüfschalter ($B_t$) enthaltendem Hochstromkreis und mit einem eine Hochspannungsquelle ($C_h$) aufweisenden vor demjenigen Strom-Null des Hochstroms, bei dem bereits eine Unterbrechungsmöglichkeit besteht,dem Prüfschalter parallelzuschaltenden, sodann einen Schwingstrom führenden Hochspannungsschwingkreis,
   **gekennzeichnet durch** folgende Merkmale:

   der Hochspannungsschwingkreis wird dem Prüfschalter parallelgeschaltet in einem Zeitabstand vor dem Strom-Null des Hochstroms ($i_1$) mit Unterbrechungsmöglichkeit, der bestimmt ist **durch**: Halbschwingungsdauer ($T_h/2$) des Schwingstroms ($i_h$) abzüglich Dauer der Äquivalenz ($\Delta t_{se}$) des alleinigen Flusses des Schwingstroms als Folgestrom im Prüfschalter mit der Beanspruchung dieses Schalters **durch** den homogenen Strom in einer direkten Prüfschaltung, wobei diese Folgestrom-Flußdauer der Äquivalenz sich zumindest näherungsweise ergibt **durch** Wertevergleich gemeinsamer physikalischer Beanspruchungsgrößen jeweils wirksam im Prüfschalter bei der Prüfung einerseits in der synthetischen Prüfschaltung und andererseits in der direkten Prüfschaltung.

2. Prüfschaltung nach Anspruch 1, **gekennzeichnet durch** folgende Merkmale:

   die Folgestrom-Flußdauer der Äquivalenz ergibt sich aus der Bedingung, daß die Emission von Lichtbogenenergie im Prüfschalter zumindest in einem jeweils annähernd gleich großen Zeitintervall vor dem letzten Strom-Null einerseits in der synthetischen Prüfschaltung und andererseits in der direkten Prüfschaltung zumindest annähernd gleich groß ist.

3. Prüfschaltung nach Anspruch 1, 2, **gekennzeichnet durch** folgende Merkmale:

   die Folgestrom-Flußdauer der Äquivalenz ergibt sich aus dem von der Funktionsgleichung (1) beschriebenen Verhältnis der emittierten Lichtbogen-Energien (AER) einerseits in der synthetischen Prüfschaltung und andererseits in der direkten Prüfschaltung, wenn dieses Verhältnis gemäß Bestimmungsgleichung (2) den Wert Eins annimmt, wobei eine Abweichung von der so ermittelten Dauer der Äquivalenz des alleinigen Flusses des Schwingstrom im Prüfschalter maximal plus oder minus 30 % beträgt.

4. Prüfschaltung nach Anspruch 1, 2, **gekennzeichnet durch** folgende Merkmale:

   die Folgestrom-Flußdauer der Äquivalenz bezogen auf die Halbschwingungsdauer ($T_h/2$) des Schwingstroms:

$$(\Delta t_{se}) / (T_h/2) =$$

ergibt sich aus der Bestimmungsgleichung (3), wobei eine Abweichung von der so ermittelten relativen Dauer der Äquivalenz des alleinigen Flusses des Schwingstroms im Prüfschalter maximal plus oder minus 30% beträgt.

**5.** Prüfschaltung nach Anspruch 1, 2, **gekennzeichnet durch** folgende Merkmale:

die Folgestrom-Flußdauer der Äquivalenz bezogen auf die Halbschwingungsdauer ($T_h/2$) des Schwingstroms:

$$(\Delta t_{se}) / (T_h/2) =$$

ergibt sich aus der Bestimmungsgleichung (4), wobei deren Konstante im Wert so festgelegt ist, daß der damit dargestellte Funktionsgraph sich dem Funktionsgraph der Äquivalenz

$$\vartheta_{se} = f(T_h/2)$$

zumindest abschnittsweise maximal bis zum Schneiden dieser beiden Funktionsgraphen nähert und eine Abweichung von der so bestimmten relativen Dauer des alleinigen Flusses des Schwingstroms im Prüfschalter maximal plus oder minus 30 % beträgt.

**6.** Synthetische Prüfschaltung für Hochspannungs-Wechselstrom-Leistungsschalter
mit einem eine Hochstromquelle (G) in Reihenschaltung mit zumindest einem Hilfsschalter ($B_a$) und einem Prüfschalter ($B_t$) enthaltenden Hochstromkreis und mit einem eine Hochspannungsquelle ($C_h$) aufweisenden vor demjenigen Strom-Null des Hochstroms, bei dem bereits eine Unterbrechungsmöglichkeit besteht, dem Prüfschalter parallelzuschaltenden, sodann einen Schwingstrom führenden Hochspannungsschwingkreis,
**gekennzeichnet durch** folgende Merkmale:

der Hilfsschalter ($B_a$) wird zeitlich so ausgelöst, daß sich seine Kontakte im Zeitintervall einer Teilschwingung des Hochstroms ($i_1$), bei deren Strom-Null bereits eine Unterbrechungsmöglichkeit **durch** den Prüfschalter besteht, kurz vor Erreichen des Stromscheitelwerts, im Stromscheitelwert oder kurz nach Erreichen des Stromscheitelwerts trennen.

**7.** Synthetische Prüfschaltung für Hochspannungs-Wechselstrom-Leistungsschalter
mit einem eine Hochstromquelle (G) in Reihenschaltung mit zumindest einem Hilfsschalter ($B_a$) und einem Prüfschalter ($B_t$) enthaltenden Hochstromkreis und mit einem eine Hochspannungsquelle ($C_h$) aufweisenden vor demjenigen Strom-Null des Hochstroms, bei dem bereits eine Unterbrechungsmöglichkeit besteht, dem Prüfschalter parallelzuschaltenden, sodann einen Schwingstrom führenden Hochspannungsschwingkreis,
**gekennzeichnet durch** folgende Merkmale: dem Hilfsschalter ($B_a$) ist ein zunächst offener Stromkreis bestehend aus einer spannungführenden Kapazität ($C_2$) in Reihe mit mindestens einem strombegrenzenden Widerstand parallelgeschaltet, und dieser Stromkreis wird vor einem Strom-Null des Hochstroms mit Unterbrechungsmöglichkeit **durch** den Prüfschalter mittels einer Schaltvorrichtung geschlossen, woraufhin sich dem Hochstrom im Hilfsschalter ein Strom relativ kleinerer Amplitude und entgegengesetzter Polarität überlagert, der spätestens im Zeitpunkt des Strom-Null des Hochstroms **durch** die gleiche oder **durch** eine andere Schaltvorrichtung unterbrochen wird.

**8.** Prüfschaltung nach Anspruch 7, **gekennzeichnet durch** folgende Merkmale:

dem Hilfsschalter wird vor dem letzten Strom-Null des Hochstroms ($i_1$) mittels einer steuerbaren Schaltfunkenstrekke ($SG_2$) eine die Spannung ($U_2$) führende Kapazität ($C_2$) in Reihe mit mindestens einer Induktivität ($L_2$) parallelgeschaltet, woraufhin sich dem Hochstrom ein Schwingstrom ($i_2$) relativ kleinerer Amplitude und höherer Frequenz mit entgegengesetzter Polarität überlagert, und dieser Überlagerungsstrom wird in einem Strom-Null spätestens zum Zeitpunkt des Strom-Null des Hochstroms **durch** einen Schalter ($B_2$) unterbrochen.

**9.** Prüfschaltung nach Patentanspruch 7, **gekennzeichnet durch** folgende Merkmale:

dem Hilfsschalter ($B_a$) wird vor dem letzten Strom-Null des Hochstroms ($i_1$) mittels einer steuerbaren Schaltfunkenstrecke ($SG_2$) eine die Spannung ($U_2$) führende Kapazität ($C_2$) in Reihe mit mindestens einem ohmschen Widerstand ($R_2$) parallelgeschaltet, woraufhin sich dem Hochstrom ein aperiodischer Strom ($i_2$') relativ kleierer Amplitude mit entgegengestzter Polarität überlagert, und dieser Überlagerungsstrom wird in einem Strom-Null spätestens zum Zeitpunkt des Strom-Null des Hochstroms **durch** einen Schalter ($B_2$) unterbrochen.

**10.** Prüfschaltung nach Anspruch 7, 8, 9, **gekennzeichnet durch** folgende Merkmale:

der Hilfsschalter ($B_a$) wird zeitlich so ausgelöst, daß sich seine Kontakte im Zeitintervall einer Teilschwingung des Hochstroms ($i_1$), bei deren Strom-Null bereits eine Unterbrechungsmöglichkeit **durch** den Prüfschalter besteht, kurz vor Erreichen des Stromscheitelwerts, im Stromscheitelwert oder kurz nach Erreichen des Stromscheitelwerts trennen.

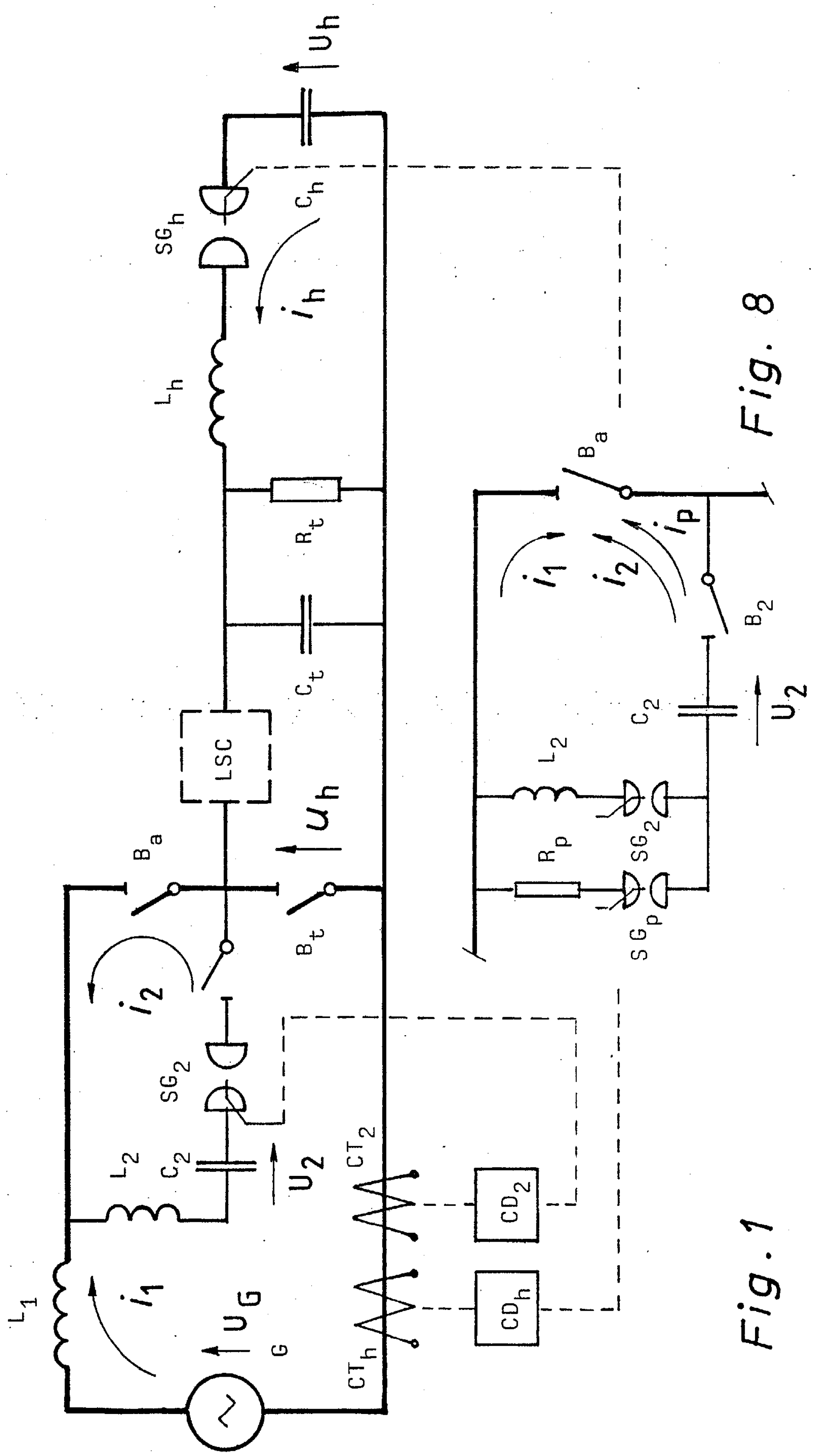
L1
i1
UG
G
CTh
CDh
L2
C2
U2
CT2
CD2
SG2
i2
Ba
Bt
uh
LSC
Ct
Rt
Lh
ih
SGh
Ch
Uh
Rp
SGp
B2
ip

Fig. 1

Fig. 8

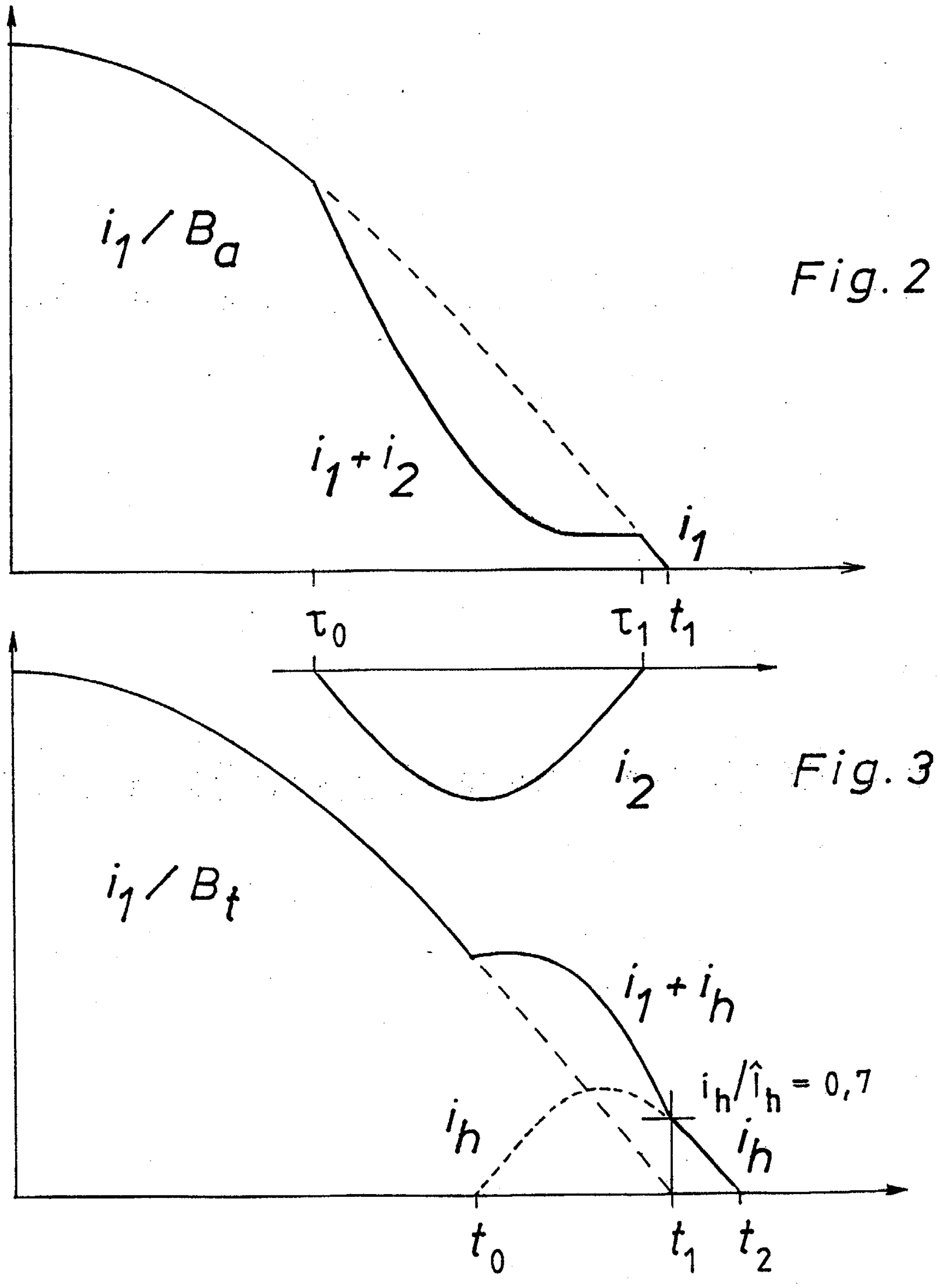


Fig. 2

Fig. 3

Fig. 4

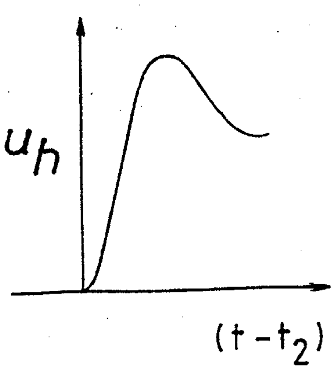


Fig. 5

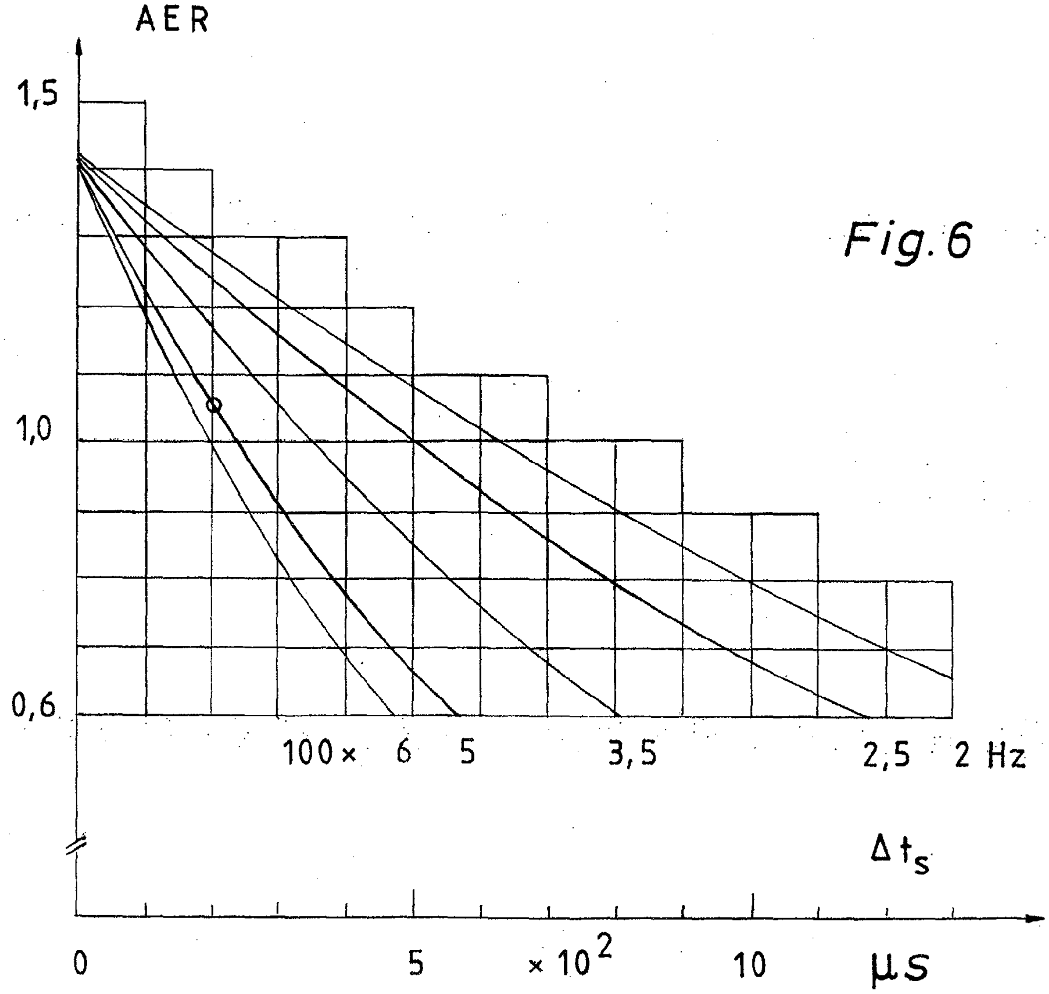
AER
1,5
1,0
0,6
100 × 6 5 3,5 2,5 2 Hz
Δ$t_s$
0
5
× $10^2$
10
μs

Fig.6

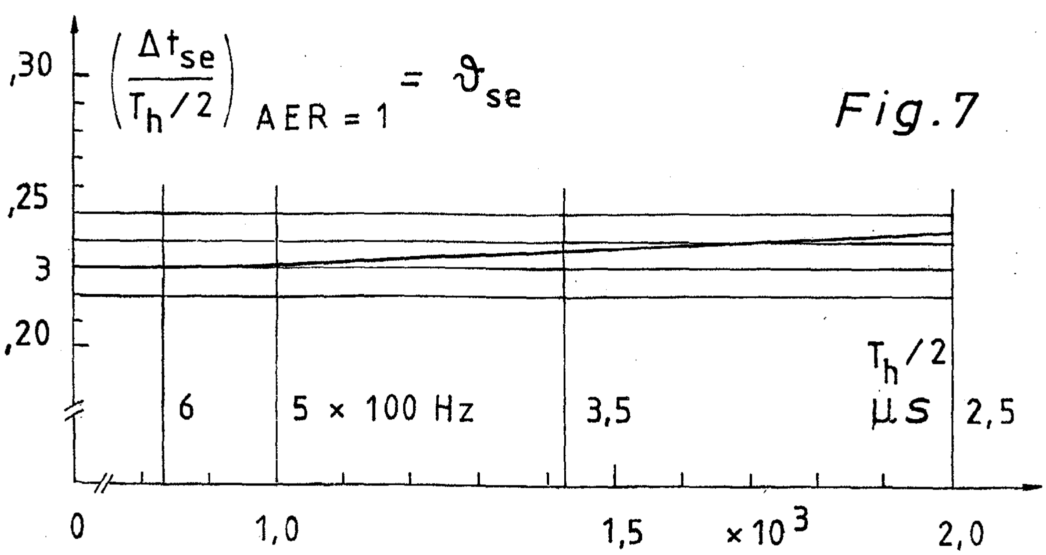
,30
,25
3
,20
$\left(\frac{\Delta t_{se}}{T_h/2}\right)_{AER=1} = \vartheta_{se}$
6
5 × 100 Hz
3,5
$T_h/2$
μs
2,5
0
1,0
1,5
× $10^3$
2,0

Fig.7

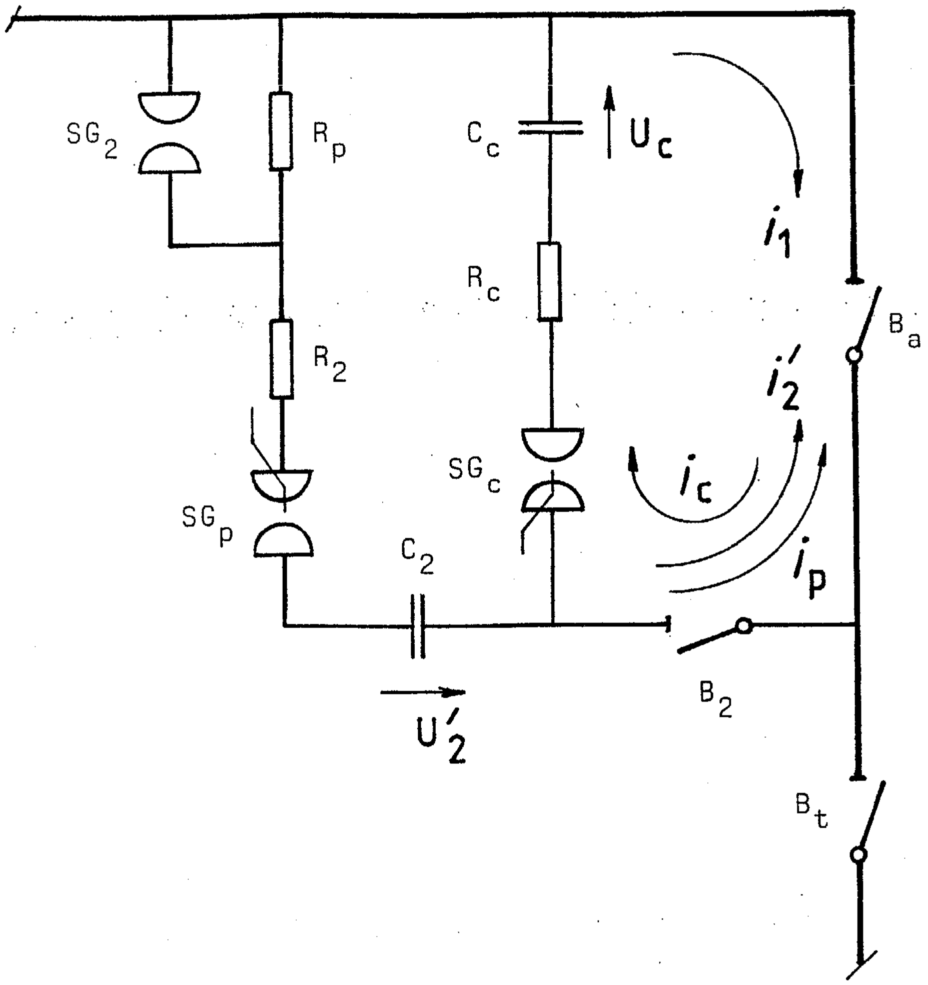


Fig. 9

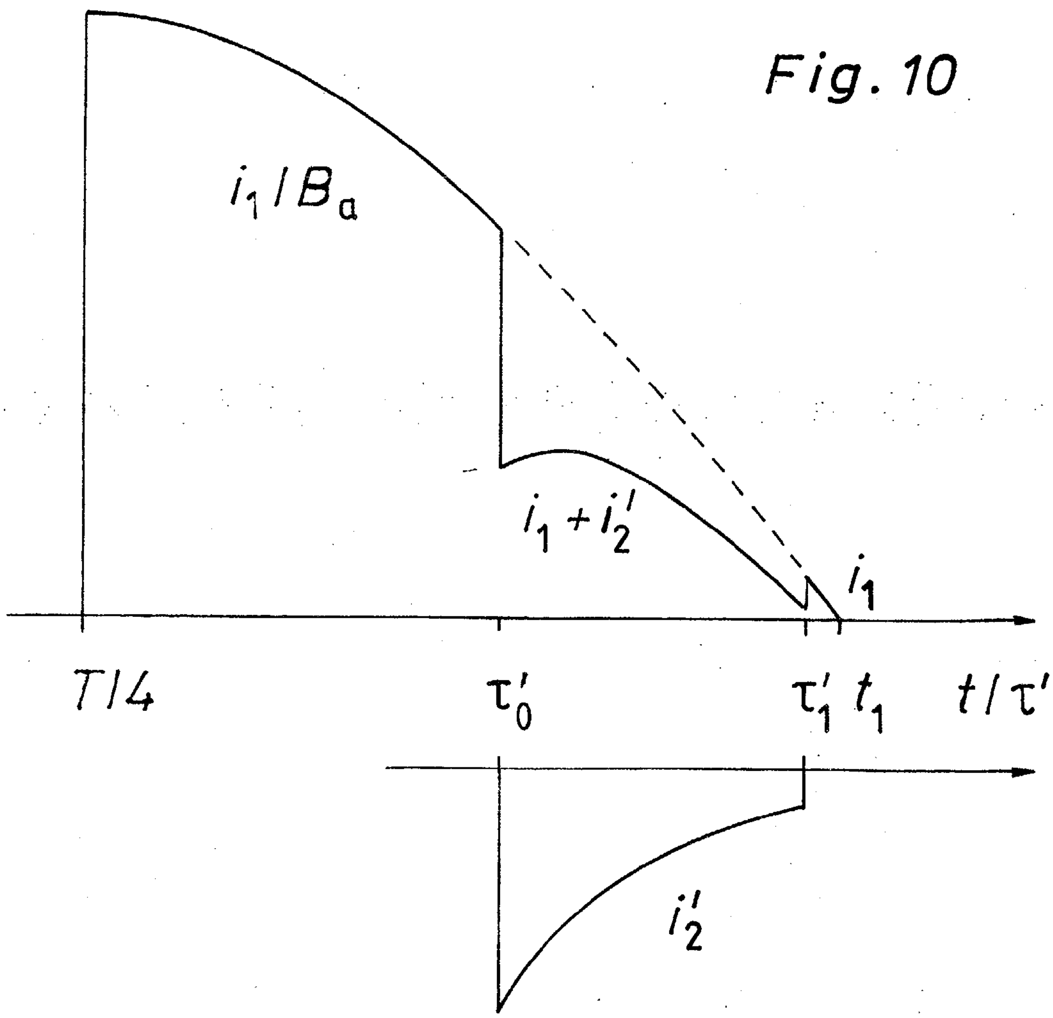


Fig. 10

Fig. 11

Funktionswerte-Tabelle 1

| $f_h$ Hz | Graph Nr. bzw. Glg. Nr. k= ... | $\Delta t_{se}$ µs | p % | | $\Delta t_{se}(1 \pm \frac{p}{100}) = \Delta t_{se}(p)$ µs | $\frac{AER(p)}{AER_e}$ % |
|---|---|---|---|---|---|---|
| 500 | Fig. 7, 0 | 230 | +30 / -30 | +/- | 299 $^{0}/_{0}$ 161 | 90 $^{0}/_{0}$ 111 |
| 500 | 3 0,00/0,03 | 231 $^{0}/_{3}$ 244 | +30 / -30 | + | 299 $^{0}/_{3}$ 317 | 90 $^{0}/_{3}$ 90 |
| 500 | 3 0,00/0,03 | 231 $^{0}/_{3}$ 244 | +30 / -30 | - | 161 $^{0}/_{3}$ 171 | 111 $^{0}/_{3}$ 112 |
| 250 | Fig. 7, 0 | 488 | +30 / -30 | +/- | 634 $^{0}/_{3}$ 341 | 89 $^{0}/_{3}$ 111 |
| 250 | 3 0,00/0,03 | 486 $^{0}/_{3}$ 502 | +30 / -30 | + | 631 $^{0}/_{3}$ 653 | 90 $^{0}/_{3}$ 90 |
| 250 | 3 0,00/0,03 | 486 $^{0}/_{3}$ 502 | +30 / -30 | - | 340 $^{0}/_{3}$ 351 | 111 $^{0}/_{3}$ 113 |

*Fig. 12*

Funktionswerte-Tabelle 2

| $f_h$ Hz | $\vartheta_{sc} = 0,24$ $\frac{AER(0,24xT_h/2)}{AER_e}$ % k=0,00/0,03 | p % | | $\Delta t_{sc}(1 \pm \frac{p}{100}) = \Delta t_{sc}(p)$ µs | $\frac{AER(p)}{AER_e}$ % k=0,00/0,03 |
|---|---|---|---|---|---|
| 600 | 99 0/3 100 | +30 / -30 | + | 260 | 88 0/3 91 |
| | | | - | 140 | 109 0/3 112 |
| 500 | 99 0/3 100 | | + | 312 | 88 0/3 91 |
| | | | - | 168 | 110 0/3 112 |
| 350 | 100 0/3 102 | | + | 446 | 89 0/3 92 |
| | | | - | 240 | 111 0/3 113 |
| 250 | 101 0/3 102 | | + | 624 | 90 0/3 92 |
| | | | - | 336 | 112 0/3 113 |
| 200 | 101 0/3 104 | | + | 780 | 91 0/3 92 |
| | | | - | 420 | 113 0/3 115 |

*Fig. 13*